# EUROPEAN PATENT APPLICATION

(11) **EP 4 318 944 A1**
(43) Date of publication of application: **07.02.2024**
(21) Application number: 23179856.2
(22) Date of filing: 16.06.2023
(51) Int. Cl.: H03F 3/60, H03F 1/02, H03F 1/30, H03F 1/56

(54) **BIASING OF TRAVELLING WAVE AMPLIFIERS**

(30) Priority: 05.08.2022 US 202217817816
(71) Applicant: Semtech Corporation, Camarillo CA 93012-8790 (US)
(72) Inventor: DUFF, Christopher Iain, Lancashire (GB)
(74) Representative: Haseltine Lake Kempner LLP

(57) **Abstract**

Amplifier circuitry is disclosed which has a travelling wave amplifier (101) with a plurality of amplifier elements (102) connected between an input transmission line and an output transmission line, the transmission lines extending between first and second sides of the travelling wave amplifier (101). The input transmission line is configured to receive an input signal at the first side and the output transmission line is configured to output an output signal at the second side. The circuitry includes biasing circuitry for applying a DC bias to the output transmission line at at least one point upstream of a last amplifier element (n).

## Description

### Technical Field

The present disclosure is related to apparatus and methods for biasing of travelling wave amplifiers.

### Background

There are various applications where amplification of broadband RF input signals is desirable, for instance for drivers for data transmission, which could be optical drivers, such as EML drivers or the like, in which an input electrical signal may be amplified to driver a suitable laser modulator. In such applications, a distributed travelling wave structure may be used to provide broadband amplification, as a travelling wave amplifier (TWA) can provide gain over a wide range from DC up to relatively high frequencies.

As will be understood by one skilled in the art, a TWA can be implemented by a plurality of amplifier elements, typically transistors, connected between a common input transmission line and a common output transmission line, the transmission lines extending from a first side to a second side of the TWA. The input signal for the TWA is applied to the input transmission line on the first side of the TWA and the output signal is taken from the output transmission line on the second side.

The input transmission line may be terminated at the second side of the TWA to prevent unwanted signal reflection, and likewise the output transmission line may be terminated at the first side to terminate any signals propagating in reverse.

A power supply for the TWA may be provided from a DC supply voltage to the TWA output via a bias tee arrangement. As will be understood by one skilled in the art, a bias tee is a form of diplexer network, which may be used to separately combine RF signals with a DC bias. In the application to a TWA, the bias tee may be coupled to the TWA output via a choke arrangement which is designed so as to isolate the DC supply and RF signal output from one another and to allow the TWA output signal to pass with minimal degradation whilst providing the required DC bias. Generally, to ensure sufficient isolation between the DC supply and RF signal across the whole range of frequencies, the bias tee network may comprise inductors and ferrites which may be difficult to practically integrate as part of an integrated circuit with the TWA. Thus, at least part of the bias tee network may be implemented by external, i.e. off-chip, components. However, achieving acceptable broadband performance can be challenging due to space and cost constraint for off-chip components and, in general, there may be a desire to integrate as much circuitry as possible

### Summary

Embodiments of the present disclosure relate to methods and apparatus for biasing of a travelling wave amplifier.

According to some embodiments there is provided amplifier circuitry comprising a travelling wave amplifier comprising a plurality of amplifier elements connected between an input transmission line and an output transmission line extending between first and second sides of the travelling wave amplifier. The input transmission line is configured to receive an input signal at the first side and the output transmission line is configured to output an output signal at the second side. The amplifier circuitry includes biasing circuitry for applying a DC bias to the output transmission line at at least one point upstream of a last amplifier element.

In some examples, the biasing circuity may comprise at least one bias transistor configured to operate as a current source. The at least one bias transistor may comprise a first bias transistor configured as part of a termination network coupled to the output transmission line at the first side of the travelling wave amplifier, wherein the termination network is configured to provide termination of any signals traveling backwards on the output transmission line. The termination network may comprise a first current path between a first terminal for receiving a DC supply voltage and the output transmission line, the first current path comprising the first bias transistor and a first resistor located in the current path between the first bias transistor and the output transmission line. A gate or base terminal of the first bias transistor may be connected to a feedback node of first current path between the first resistor and the output transmission line. The gate or base terminal of the first bias transistor may be connected to said feedback node via a second resistor.

In some examples, the termination network may also comprise a third resistor in parallel with the first bias transistor. IN some examples, the first current path may further comprise at least one impedance element between the first resistor and the output transmission line configured to provide an equivalent series inductance to match at least some of the source capacitance of the bias transistor. In some examples, the first current path may further comprise at least one impedance matching network between the first terminal for receiving the DC supply voltage and the bias transistor, wherein the impedance matching network is configured to compensate for at least one of: any inductance of external components connected, in use, to the first terminal; and an electrostatic discharge circuit connected to the first current path. In some examples, the first terminal for receiving a DC supply voltage is also configured for connection to an external capacitance for AC decoupling.

In some examples, the biasing circuity may comprise a plurality of bias transistors, each bias transistor being configured to operate as a current source and to supply bias current to the output transmission line between adjacent amplifier elements. The biasing circuitry may comprise a voltage supply path connected to a first terminal for receiving a DC supply voltage. Each of the plurality of bias transistors may be located in a respective current path between the voltage supply path and a respective connection point to the output transmission line with a respective series resistor located in the respective current path between the bias transistor and the output transmission line. A gate or base terminal of each bias transistor may be connected to a respective feedback node of the respective current path between the series resistor and the output transmission line. The biasing circuitry may comprise a current path with a respective bias transistor for supplying bias to the output transmission line between each adjacent pair of amplifier elements. At least one capacitor may be coupled between the voltage supply path and a defined voltage.

The first terminal for receiving the DC supply voltage may comprise a terminal of an output transmission line termination network, wherein the output transmission line termination network is coupled to the output transmission line at the first side of the travelling wave amplifier and is configured to provide termination of any signals traveling backwards on the output transmission line. The first terminal may also be configured to also connect to an external capacitance for AC decoupling of the output transmission line termination network. The output transmission line termination network may be configured such that, in use, a bias current flows from the first terminal to the output transmission line via the output transmission line termination network.

The amplifier circuitry may be implemented as an integrated circuit and/or as part of an electronic device.

In a further aspect there is provided amplifier circuitry comprising a travelling wave amplifier comprising a plurality of amplifier elements connected between an input transmission line and an output transmission line extending between first and second sides of the travelling wave amplifier wherein the input transmission line is configured to receive an input signal at the first side and the output transmission line is configured to output an output signal at the second side. Biasing circuitry is provided for applying a DC bias to the output transmission line, wherein the biasing circuity comprises at least one bias transistor configured to operate as a current source.

In a further aspect there is provided amplifier circuitry comprising a travelling wave amplifier comprising a plurality of amplifier elements connected between an input transmission line and an output transmission line extending between first and second sides of the travelling wave amplifier wherein the input transmission line is configured to receive an input signal at the first side and the output transmission line is configured to output an output signal at the second side. Circuitry is provided for applying a DC bias to the output transmission line at least partly via a output transmission line termination network connected to the output transmission line at the first side to terminate any signal propagating backwards on the output transmission line.

### Brief Description of the Drawings

To better explain various embodiments and examples of the present disclosure and the principles, example implementation and operation thereof, reference will now be made, by way of example, to the following drawings, in which:
Figure 1 illustrates one example of travelling wave amplifier implementation with conventional biasing; and
Figure 2 illustrates one example of travelling wave amplifier implementation with biasing according to an embodiment;
Figure 3 illustrates one example of an adaptive biasing and termination network; and
Figure 4 illustrates an example of travelling wave amplifier implementation with biasing according to another embodiment

### Detailed Description

Embodiments of the present disclosure relate to methods and apparatus for biasing of a travelling wave amplifiers.

As discussed above a travelling wave amplifier (TWA) structure may be used to provide broadband amplification for some application.

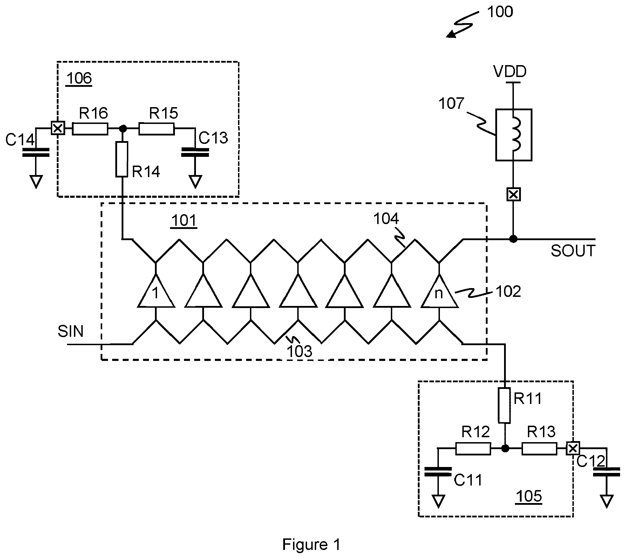

**Figure 1** illustrates one example of a conventional amplifier arrangement 100 including a travelling wave amplifier 101.

As will be understood by one skilled in the art, a TWA can be implemented by a plurality (1 - n) of amplifier elements 102 with inputs connected to a common input transmission line 103 and outputs connected to a common output transmission line 104. Typically the amplifier elements 102 may be implemented by suitable transistors, such as FETs, with their gates connected to the input transmission line 103, which is thus referred to the gate line, and their drains connected to the output transmission line 104, which is thus referred to as the drain line. The gate line 103 and drain line 104 may be implemented as artificial transmission lines, which, as will be understood by one skilled in the art, is typically a signal propagation path implemented with lumped elements, typically inductors and/or capacitors, to replicate or approximate the behavior of a transmission line. The gate line and drain line may therefore have tuned inductances (not separately illustrated) between the successive transistors along the gate line 103 and drain line 104 respectively. Note that as used herein, the term transmission line shall be taken to mean any suitable type of propagation path for propagation of the input and output signals of the travelling wave amplifier. The sources of the transistors in such a TWA are generally connected to a defined voltage, typically ground.

The input signal SIN for the TWA 101 can be applied to the input transmission line on a first side of the TWA, i.e. applied to the gate line 103 upstream of the first amplifier element, with the output signal, SOUT, being taken from the output transmission line on the second (opposite) side of the TWA, i.e. from the drain line 104 downstream of the nth amplifier element. In the example of figure 1, the TWA 101 provides a single-ended output signal SOUT, but it will be understood that a differential TWA arrangement could be implemented if desired.

The gate line 103 is terminated on the second side by a suitable termination network 105 to prevent unwanted reflection. Whilst the gate line 103 could simply be terminated by a connection to ground via a defined resistance, such a termination arrangement would lead to a DC current to ground in use, with an associated power loss. It may, therefore, be preferable in some applications to provide an AC coupled resistive termination network 105 comprising capacitance and resistance, that provides a tuned impedance to prevent unwanted signal reflection but without a DC current flow to ground.

Whilst, the required components of the termination network, i.e. resistors and capacitors, could be implemented as part of an integrated circuit with the TWA, the value of capacitance required to provide good broadband termination performance down to low frequencies may be relatively high, and implementing such a capacitor as an internal, i.e. on-chip component, may not be practical in terms of the required circuit area and cost. Therefore at least some capacitance for the termination network may be provided by one or more off-chip components, i.e. an external component to the integrated circuit die. Figure 1 illustrates that the gate line 103 may be termination by an on-chip termination network 105 comprising a termination resistance R11, de-Q resistors R12 and R13 and an on-chip capacitance C11, with a connection for external, i.e. off-chip, capacitance, represented by C12. Note that figure 1 illustrates C12 as a single capacitance for simplicity, but in practice C12 may comprise a decoupling capacitor network, as will be understood by one skilled in the art.

It is also advantageous to terminate the drain line 104 on the first side of the TWA to terminate any signal propagating in the reverse direction along the output transmission line. Thus, the drain line 104 may be connected, on the first side of the TWA, to an on-chip termination network 106, which may for instance have a similar arrangement of resistances and capacitance as the termination network 105, with on-chip resistances R14, R15 and R16 and on-chip capacitance C13 and a connection to external capacitance C14.

Note it will be understood that other arrangement of termination network could be implemented, for instance including de-Q resistors for damping resonances. It will also be understood that there may be some ESD (electrostatic discharge) protection circuitry coupled to the external contacts.

Biasing of the TWA may generally be provided by a DC supply voltage VDD. Figure 1 illustrates a conventional biasing arrangement where the DC supply voltage is coupled to the TWA output in a bias tee arrangement where the DC voltage VDD is coupled to TWA output via a choke network 107. The choke network typically comprises components such as ferrites and inductors, as would be understood by one skilled in the art, and is configured to choke off the VDD supply to RF energy over the circuit operating bandwidth so that there is a predominantly DC energy flow between the VDD supply and the TWA output. This enables circuit bias, with efficient energy flow to the TWA output. To provide sufficient isolation between the DC supply and RF output signal SOUT, the choke network 107 may comprise inductors and ferrites that may not be practically formed as part of an integrated circuit with the TWA and thus the choke network may be formed by off chip components.

Note it will be understood be one skilled in the art that other bias voltages may be applied at other parts of the amplifier arrangement, for instance to control the quiescent bias points of the various transistors of the amplifier arrangement to be controlled, but such other bias voltages, which may be supplied separately, have been omitted from figure 1 for clarity.

Whilst the bias tee arrangement for powering the TWA described with reference to figure 1 is satisfactory for many implementations, the requirement for off-chip components can have space and cost implications and there may be trade-offs in terms of space, cost and performance.

Embodiments of the present disclosure relate to improvements in biasing of a TWA that can reduce or eliminate the need for external components such as bias tee network as described with reference to figure 1. In embodiments of the invention bias may be applied to the output transmission line, i.e. the drain line, upstream of the final amplifier element. Conveniently the DC voltage may be supplied via a connection to the drain line termination network.

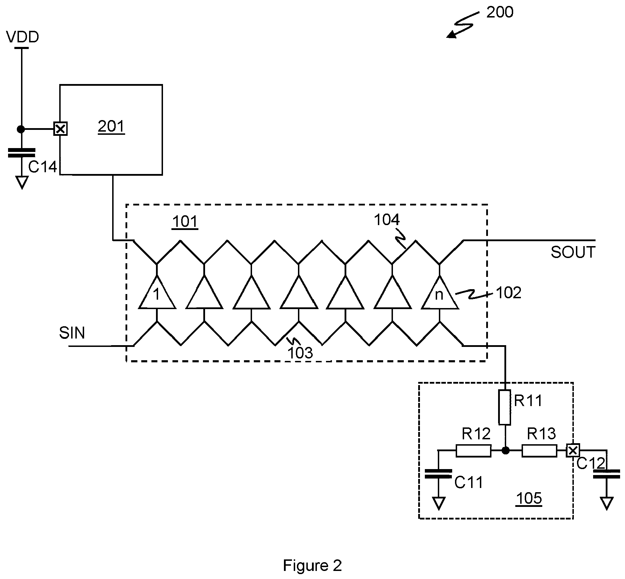

**Figure 2** illustrates one example of an amplifier arrangement 200 according to an embodiment, in which similar components as discussed with reference to figure 1 are identified by the same references.

Figure 2 again illustrates a TWA 101 which has an input transmission line 103 for receiving an input signal SIN at a first side of the TWA and an output transmission line 104 for outputting an output signal SOUT at a second side of the TWA. A plurality (1... n) of amplifier elements 102 are connected between the input transmission line 103 and the output transmission line 104. As discussed above the amplifier elements 102 may be transistors, such as FETs, with their gates connected to the input transmission line, which will thus be referred to as the gate line 103, their drains connected to the output transmission line, which will be referred to as the drain line 104, and their sources connected to a defined voltage, typically ground.

As discussed above, the gate line 103 is terminated at the second side of the TWA 101 by a termination network 105.

The drain line 104 is also terminated at the first side of the TWA 101 by a suitable termination network. However, in this example, the supply voltage VDD is provided to the TWA at this drain line termination via the termination network, and thus drain line 104 is connected, at the first side of the TWA amplifier to a network 201 which is a combined termination and bias supply network. The supply voltage VDD may be supplied to this network 201 via the same connection as for an external capacitance C14, which as discussed above, may be present anyway as part of the normal termination arrangement. Supplying the supply voltage VDD via the network 201 in this way thus eliminates the need for a bias tee with external choke components and the DC supply voltage VDD may be received on chip via a connection terminal that would, in any case, be present.

It would be possible for the network 201 to have essentially the same structure as the termination network 106 discussed with reference to figure 1. However, it will be noted that the conventional bias tee arrangement of figure 1 allows the RF signal voltage to swing above and below the quiescent DC operating point, whereas for the arrangement of figure 2, the supply voltage VDD must be sufficient to provide headroom for the highest voltage that will appear at this end of the drain line (i.e. at the first side of the TWA 101). If the supply voltage VDD were applied to external contact of the resistive network 106 illustrated in figure 1, then, at times of high current draw, the voltage drop across the resistive network, e.g. resistors R14 and R16, would be relatively high. This would require the supply voltage VDD to be relatively very high to provide sufficient headroom, which may be undesirable.

In some embodiments, therefore, the network 201 may be an active transistor network which acts as a current source to provide the required bias current, whilst maintaining the required impedance for terminating any signals propagating backwards along the drain line 104.

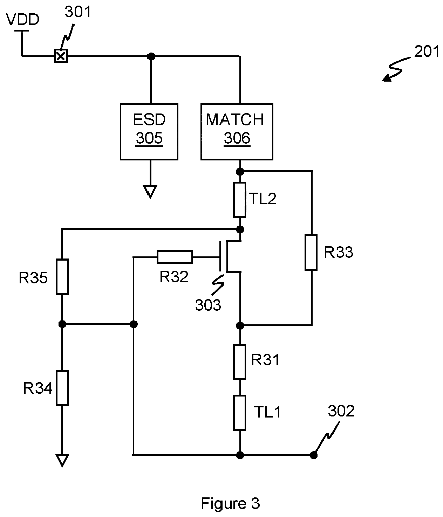

**Figure 3** illustrates one example of a suitable network 201 for the active biasing and termination network 201 of figure 2. Figure 3 illustrates that the DC supply voltage VDD may be received at a terminal 301. As discussed with reference to figure 2, the terminal 301 may also be used connect to an off-chip capacitance (not separately illustrated in figure 3) for AC decoupling. The network 201 may also connect to the first end of the drain line 104 at a drain line termination node 302.

The active network 201 comprises a bias transistor 303. The bias transistor 303, which in this example may be a FET is arranged in a current path between the supply voltage terminal 301 and the drain line termination node 302 and is controlled to act as a current source. It will be understood, however, that the transistor need not be a FET and could implemented in other ways. For the example of figure 3, the transistor 303 may be biased at a similar quiescent bias point to the transistors of the amplifier elements 102 of the TWA, so that their characteristics track each other relatively closely with operating conditions, e.g. with PVT (process, temperature and voltage) variations.

Resistor R31 is connected in series in the current path, between the source of transistor 303 and the drain line termination node 302. The gate of the transistor 303 is connected to node of the current path, which may be referred to a feedback node, which is downstream of the resistor R31, i.e. between resistor R31 and the drain line termination node 302, so that the current through R31 results in a voltage drop across R31 that provides negative feedback across the gate-source junction of transistor 303. The gate source voltage acts through the transconductance of transistor 303 to control the drain source current, so that the transistor operates as a current source.

The gate of the bias transistor 303 is connected to the feedback node via resistor R32, which is provided to stabilize the transistor 303 and avoid oscillation. The gate current of the transistor 303 is negligible and hence there is a negligible voltage drop across R32.

As will be discussed in more detail below, the bias transistor 303 is arranged in parallel with resistor R33 to share the overall bias current and resistor R31 may be arranged, as illustrated, to pass the total bias current through both the transistor 303 and parallel resistor R33. Alternative, resistor R31 may be arranged to pass only the bias current through the transistor 303, with resistor R33 in parallel with the series combination of transistor 303 and resistor R31.

To operate as termination network, the network should, looking into the drain line termination node 302, present a good broadband match to the drain line 104 of the TWA 101 and should absorb and terminate travelling wave energy propagating backwards along the drain line 104 to the drain line termination node 302.

As noted above, the bias transistor 303 is arranged in parallel with resistor R33 so that the bias transistor 303 and resistor R33 share the total bias current. The quiescent operating point of the bias transistor 303 may be set by selecting a suitable channel width for the bias transistor 303 and value of resistance for R31 so that the parallel combination of R33 and bias transistor 303 share the bias current whilst optimizing the network impedance presented at the drain line termination node 302.

Resistors R34 and R35 are configured to set the transistor gate bias voltage so that the supply voltage VDD is appropriately divided between the bias circuitry and the transistors of the amplifier elements 102 of the TWA 101.

In the example of figure 3, high impedance transmission line TL1 is used to present an equivalent series inductance to match some of the source capacitance of transistor 303 and TL2 represents the electrical length of the interconnect between the drain of transistor 303 and the parallel resistance R33.

As illustrated in figure 3, some ESD protection circuitry 305 may be coupled to supply terminal 301, as would be understood be one skilled in the art. A matching network 306, e.g. of suitable impedance elements such as resistances and/or capacitances, may be provided (if required) to provide further matching to compensate for the interaction of the capacitance of the ESD circuitry with any off-chip inductance and decoupling network so as to tune the impedance of the network 201 as seen by the drain line 104 at the drain line termination node 302.

The termination and biasing network 201 can thus be configured to provide good matching for termination of backward propagating signals along the drain line 104, whilst also providing suitable biasing without requiring any external components such as a choke network. Avoiding the external choke network can be beneficial in terms of space and cost and the biasing and termination network 201 may exhibit better performance than may be possible with the conventional bias tee arrangement. In addition, the supply voltage VDD may be brought on chip using the same connection as used for an external capacitance of the termination network, which can reduce the number of external connections required, saving on-chip circuit area and cost.

Figure 2 illustrates that the biasing may be applied to the drain line 104 via the drain line termination node. In some embodiments, at least some bias may additionally or alternatively be applied at one or more points along the drain line 104, for instance to the drain line between connection between successive amplifier elements 102.

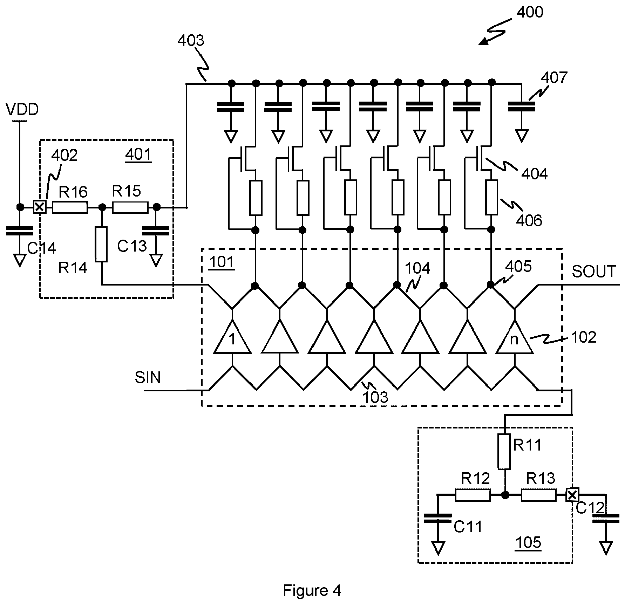

**Figure 4** illustrates one example of an amplifier arrangement 400 according to an embodiment in which biasing is applied to the drain line between amplifier elements. In figure 4, similar elements to those discussed previously are identified using the same references.

Again figure 4 illustrates a TWA 101 having amplifier elements 102, i.e. transistors, connected between an input gate line 103 and an output drain line 104. The input signal SIN is applied to the gate line 103 on the first side of the TWA 101 and the output signal SOUT is taken from the drain line 104 on the second, opposite, side of the TWA 101. The gate line 103 is terminated at the second side by a termination network 105 as discussed previously.

The drain line 104 is terminated at the first side by a termination network 401, which may, in this example, have generally the same structure the termination network 106 discussed with reference to figure 1, except that the termination network 401 may also be used to receive the supply voltage VDD.

In the example of figure 4, biasing is applied at multiple points along the drain line 104, between the connection points for the successive amplifier elements.

The supply voltage VDD is thus received at a terminal 402 which may also be used to connect to off-chip capacitance C14 for AC decoupling. The supply voltage may pass through de-Q resistors R16 and R15 and be provided to a supply path 403. A plurality of transistors 404, referred to herein as bias transistors, are coupled between the supply path 403 and respective connection points 405 along the drain line 104. The bias transistors 404 are configured to operate as current sources, each supplying part of the bias current for the TWA 101 along the drain line 104. A respective resistor 406 is coupled between the source of each bias transistor 404 and the drain line 104, with the gate of the bias transistor 404 being connected downstream of the resistor 406, so that the potential difference across the resistor 406 due to the drain-source current through the transistor provides negative feedback across the gate-source junction, in a similar manner as discussed with respect to figure 3. This means that each bias transistor 404 acts a respective current source. Compared with the example of figure 3, the single active transistor 303 of the embodiment of figure 3 can be considered, in the example of figure 4, as being split into the plurality of bias transistors 404 for supplying bias at different points alone the bias line. Each of the individual bias transistors 404 may thus only need to pass a fraction of the overall bias current and the transistors 404 can be smaller than would be the case for the active transistor 303 of the example of figure 3.

Each of the transistors 404 can be biased at a similar quiescent bias to the transistors of the TWA 101, so that their characteristics track closely over expected PVT variations.

A plurality of capacitors 407 may be coupled to the supply path 403, around the drain connections for the transistors 404, to decouple the supply path 403 at high frequencies. In the example of figure 4, capacitance C13 of the termination network 401 also provides some decoupling for the supply path 403.

It should be noted that whilst figure 4 illustrates an example where the supply voltage VDD is coupled to a terminal 402 of the termination network 401 and passes through de-Q resistors R15 and R16 of the termination network to the supply path 403, it would be possible to supply the voltage VDD to the supply path via some other connection, that bypasses the drain line termination network. For instance, the supply voltage could be received at a separate terminal and supplied directly to the supply line 403.

However, receiving the supply voltage VDD via the termination network 401 can be advantageous. As noted above, the supply voltage VDD may be received via a terminal 402 that would be required for an off-chip connection in any case, eliminating the need for a separate VDD terminal and the on-chip capacitance C14 can aid in decoupling of the supply path 403. In addition, providing the supply voltage VDD in this way means that some bias current will flow to the drain line with resistance R14 of the termination network. This means that the transistors 404 can be smaller than would be the case if they were collectively supplying the whole bias current. This can be advantageous as reducing the size of the bias transistors reduces the shunt capacitive loading on the drain line, acting in parallel with the output capacitance of the TWA. Such loading can affect wave propagation along the drain line, requiring different optimization, and thus a low capacitive loading may be desirable.

Figure 4 illustrates that bias is supplied to the drain line 104 by a respective bias transistor between each of the amplifier elements 102. This arrangement may be advantageous in terms of spreading loading and ensuring uniformity of the sections of the TWA so as preserve broadband performance. However, in some implementations there could be fewer bias transistors and there may be one or more sections of the drain line 104 between adjacent amplifier elements 102 which are not provided with bias.

As discussed above, the termination network 401 should present a good broadband match to the drain line 104 of the TWA 101 and should absorb and terminate travelling wave energy propagating backwards along the drain line 104. The broadband impedance presented by the termination network 401 can be optimized by setting the values of the resistances R14, R15 and R16 together with the sizes of the bias transistors 404 and series resistance 406. The overall network topology provides the capability to optimize the broadband termination performance and overall TWA gain flatness.

In general, therefore, embodiments of the present disclosure relate to biasing of a TWA. Instead of the conventional approach, where biasing is applied to the output of the drain line, i.e. downstream of the last amplifier element, in embodiments of the present disclosure bias is applied to the drain line upstream of the last amplifier element. In some cases the bias may be applied to the drain line termination node on the first (input) side of the TWA. In some case bias may be applied to one or more points along the drain line, at feed in points between adjacent amplifier elements. The bias may be applied by one or more active bias transistors which may be controlled as a current source. This can allow the bias to applied without requiring an unduly high supply voltage to provide sufficient headroom. The supply voltage may be supplied to the integrated circuit without requiring any external choke network or the like. Conveniently the supply voltage may be brought on-chip via a termination network for the drain line.

Embodiments of the present disclosure may be used for amplifiers for broadband amplification in signal drivers for communication. As noted, at least some embodiments may be suitable for use in optical drivers, e.g. for EML or other drivers for optical communications, or for some electrical communication drivers.

Embodiments may be implemented as an integrated circuit. Embodiments also relate to electronic devices including an amplifier arrangement as described herein.

The embodiments above have been described with reference to a TWA formed by transistors such as FETs, with the input transmission line being a gate line and the output transmission line being a drain line, but one skilled in the art will appreciate that other transistor technologies, such as bipolar, could be used to implement the TWA.

It will be understood that the examples and embodiments described above are given by way of example only and those skilled in the art will understand that modifications, variations, additions or alterations may be made to specific embodiments described, or alternative embodiments may be implemented, without departing from the scope of the appended claims.

It should be noted that as used herein, unless expressly stated otherwise, the word "comprising" does not exclude the presence of other elements or steps other than those listed, references to an element or feature in the singular does not exclude the possibility of a plurality of such elements or features, and that recitation of different features or elements in the appended claims does not necessarily imply separate components; a single component or unit may fulfil the function of several elements recited in a claim. Any reference signs in the appended claims shall not be construed so as to limit their scope.

## Claims

1. Amplifier circuitry comprising:
a travelling wave amplifier comprising a plurality of amplifier elements connected between an input transmission line and an output transmission line extending between first and second sides of the travelling wave amplifier wherein the input transmission line is configured to receive an input signal at the first side and the output transmission line is configured to output an output signal at the second side; and
biasing circuitry for applying a DC bias to the output transmission line at at least one point upstream of a last amplifier element.

2. The amplifier circuitry of claim 1 wherein the biasing circuity comprises at least one bias transistor configured to operate as a current source.

3. The amplifier circuitry of claim 2 wherein the at least one bias transistor comprises a first bias transistor configured as part of a termination network coupled to the output transmission line at the first side of the travelling wave amplifier, wherein the termination network is configured to provide termination of any signals traveling backwards on the output transmission line.

4. The amplifier circuitry of claim 3 wherein the termination network comprises:
a first current path between a first terminal for receiving a DC supply voltage and the output transmission line, the first current path comprising the first bias transistor; and
a first resistor located in the current path between the first bias transistor and the output transmission line;
wherein a gate or base terminal of the first bias transistor is connected to a feedback node of first current path between the first resistor and the output transmission line.

5. The amplifier circuitry of claim 4 wherein the gate or base terminal of the first bias transistor is connected to said feedback node via a second resistor.

6. The amplifier circuitry of claim 4 or claim 5 wherein the termination network comprises a third resistor in parallel with the first bias transistor.

7. The amplifier circuitry of any of claims 4 to 6 wherein the first current path further comprises at least one impedance element between the first resistor and the output transmission line configured to provide an equivalent series inductance to match at least some of the source capacitance of the bias transistor.

8. The amplifier circuitry of any of claims 4 to 7 wherein the first current path further comprises at least one impedance matching network between the first terminal for receiving the DC supply voltage and the bias transistor, wherein the impedance matching network is configured to compensate for at least one of:
any inductance of external components connected, in use, to the first terminal; and an electrostatic discharge circuit connected to the first current path.

9. The amplifier circuitry of any of claims 4 to 8 wherein the first terminal for receiving a DC supply voltage is also configured for connection to an external capacitance for AC decoupling.

10. The amplifier circuitry of claim 2 wherein the biasing circuity comprises a plurality of bias transistors, each bias transistor being configured to operate as a current source and to supply bias current to the output transmission line between adjacent amplifier elements.

11. The amplifier circuitry of claim 10 wherein the biasing circuitry comprises:
a voltage supply path connected to a first terminal for receiving a DC supply voltage;
wherein each of said plurality of bias transistors is located in a respective current path between the voltage supply path and a respective connection point to the output transmission line with a respective series resistor located in the respective current path between the bias transistor and the output transmission line; and
wherein a gate or base terminal of each bias transistor is connected to a respective feedback node of the respective current path between the series resistor and the output transmission line.

12. The amplifier circuitry of claim 11 wherein the biasing circuitry comprises a current path with a respective bias transistor for supplying bias to the output transmission line between each adjacent pair of amplifier elements.

13. The amplifier circuitry of claim 11 or claim 12 comprising at least one capacitor coupled between the voltage supply path and a defined voltage.

14. The amplifier circuitry of any of claims 11 to 13 wherein the first terminal for receiving the DC supply voltage comprises a terminal of an output transmission line termination network, wherein the output transmission line termination network is coupled to the output transmission line at the first side of the travelling wave amplifier and is configured to provide termination of any signals traveling backwards on the output transmission line.

15. The amplifier circuitry of claim 14 wherein the output transmission line termination network is configured such that, in use, a bias current flows from the first terminal to the output transmission line via the output transmission line termination network.
